# EUROPEAN PATENT SPECIFICATION

(11) **EP 0 344 873 B1**
(45) Date of publication and mention of the grant of the patent: **15.12.1993**
(21) Application number: 89202021.5
(22) Date of filing: 30.06.1983
(51) Int. Cl.: H01L 27/02, H03K 19/177, H03K 19/086

(54) **Semiconductor integrated-circuit apparatus**
Integrierte Halbleiterschaltungsanordnung
Dispositif de circuit intégré semi-conducteur

(30) Priority: 30.06.1982 JP 112778/82; 01.07.1982 JP 114241/82; 29.12.1982 JP 233774/82; 29.12.1982 JP 230288/82
(43) Date of publication of application: 06.12.1989
(62) Divisional of application: 83303805.2
(73) Proprietor: FUJITSU LIMITED, Kawasaki-shi, Kanagawa 211 (JP)
(72) Inventor: Sugiyama, Eiji, Kawasaki-shi Kanagawa 214 (JP); Saito, Toshiharu, Kawasaki-shi Kanagawa 214 (JP); Natsume, Mitsuaki, machida-shi Tokyo 194 (JP)
(74) Representative: Skone James, Robert Edmund

(56) References cited:
- US-A- 3 872 583
- REVIEW OF THE ELECTRICAL COMMUNICATION LABORATORIES, vol. 26, nos. 9-10, September-October 1978, pages 1355-1366, Tokyo, JP; K. WADA et al.: "Master-slice layout design for emitter-coupled logic LSI"

## Description

The present invention relates to a semi-conductor circuit and in particular to the supply voltages for such a circuit.

Usually, a semi-conductor integrated circuit has two electric supply voltage systems, a high voltage side designated V_{cc} and a low voltage side designated V_{EE}. As the scale of the circuit becomes larger the electric power dissipation increases. Even in the case of the electric supply on the low-voltage side, the supply voltage may differ from point to point, and this difference cannot be ignored in some types of circuits.

The object of the present invention is to reduce inequalities in a given supply voltage at different points of the circuit.

A semiconductor integrated circuit according to the present invention comprises a semiconductor substrate in which integrated circuits are formed and on which a first power supply line layer and a second power supply line layer are formed;
a plurality of first internal pads formed on the substrate and connected to the first power supply line layer;
second internal pads formed on the substrate and connected to the second power supply line layer, the number of second internal pads being less than the number of first internal pads;
a package on which the substrate is mounted;
a plurality of first external pads formed on the package and around the peripheral area of the substrate, the first external pads being connected to the first internal pads through respective conductors;
for each second internal pad, a second external pad formed on the package and at the peripheral area of the substrate, each second external pad being connected to a second internal pad through a conductor and, each of said first and second external pads, also being connected to an external terminal lead;
and characterised by at least one third internal pad formed on the substrate and connected to the second power supply line layer;
for each third internal pad, a third external pad formed on the package and around the peripheral area of the substrate, the third external pad being connected to the third internal pad through a conductor but having no connection to an external lead; and
an electroconductive layer formed over a substantial portion of the interface between the substrate and the surface of the package, the electroconductive layer extending to and being connected to the second and the third external pads, thereby removing the need for an additional external terminal lead for the third external pad.

The provision of the third internal pad or pads connected to the second power supply line layer in combination with the provision of the electroconductive layer greatly reduces voltage differences at different points in the second power supply layer.

In order that the invention may be better understood, an embodiment of the invention will now be described with reference to the accompanying drawings in which:-
Figure 1 is a diagram of the layout of an electric source system in a conventional LSI circuit;
Figure 2 is an equivalent circuit of an ECL gate used as an internal gate of a gate array; and
Figure 3 and 4 are diagrams of the layout of the electric source system according to the present invention.

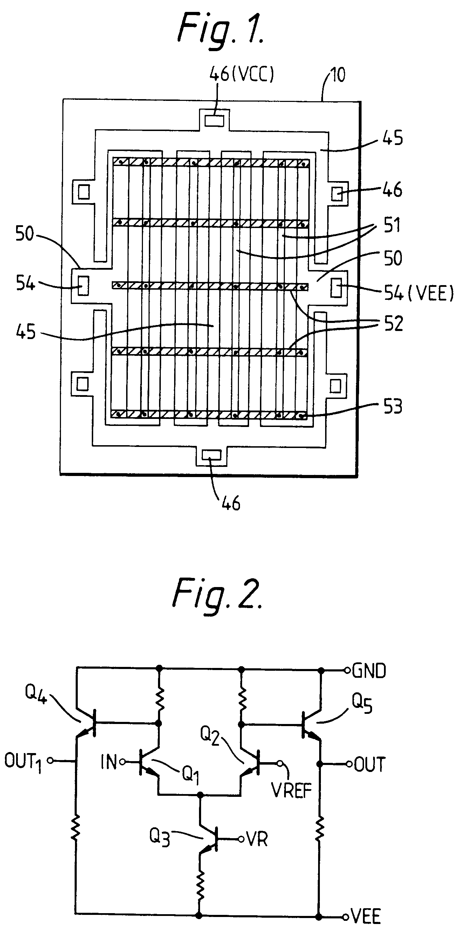

Figure 1 is a layout of an electric supply system of an LSI circuit as known, for example, from Review of the Electrical Communication Laboratories, Vol.26,(9/10), September-October 1978, p.1355-1366. In Fig. 1, 10 denotes an IC chip, 45 denotes a wiring pattern on the V_{CC} side, and 50, 51, 52 denote wiring patterns on the V_{EE} side. Wiring patterns 45, 50, 51 are formed by a first wiring layer of aluminium. A plurality of basic cells (not shown in the drawings) which have, for example, a gate circuit as shown in Fig. 2 are also formed in the IC chip 10. On the other hand , the wiring pattern 52 is formed in a transverse direction by a second wiring layer of aluminium so that it crosses the first layer and is connected to the first-layer wiring patterns 50, 51 of the V_{EE} supply at their crossing or meeting points, as shown by dots 53 in Figure 1. The first-layer wiring pattern 45 on the V_{CC} side is provided with six bonding pads 46 around its periphery. However, on the V_{EE} side, only two bonding pads 54 are provided for the wiring pattern.

The longitudinal wiring patterns 50, 51 on the V_{EE} side are independent, and, as mentioned above, points thereof are connected to another wiring pattern extending in a transverse direction. However, because the longitudinal patterns 50, 51 have only the two pads 54 the electric source voltage V_{EE} varies from point to point in the chip. This variation, which becomes more evident as the circuit scale becomes larger and the electric power dissipation increases, cannot be ignored in some types of circuits.

For example, in the ECL gate shown in Fig. 2, Q₁, Q₂ are transistors for forming a current switch, Q₃ is a transistor for a constant-current source, and Q₄, Q₅ are transistors connected as emitter followers for the output stage. A base voltage V_{R} of the transistor Q₃ for a constant current source is set with respect to the V_{EE} side. However, if V_{EE} is different, the constant current becomes different so that the output voltage becomes different. To compensate for this, the value of the emitter resistor may be changed. However, it is very troublesome and impractical to change the value of each emitter resistor according to the position of the gate.

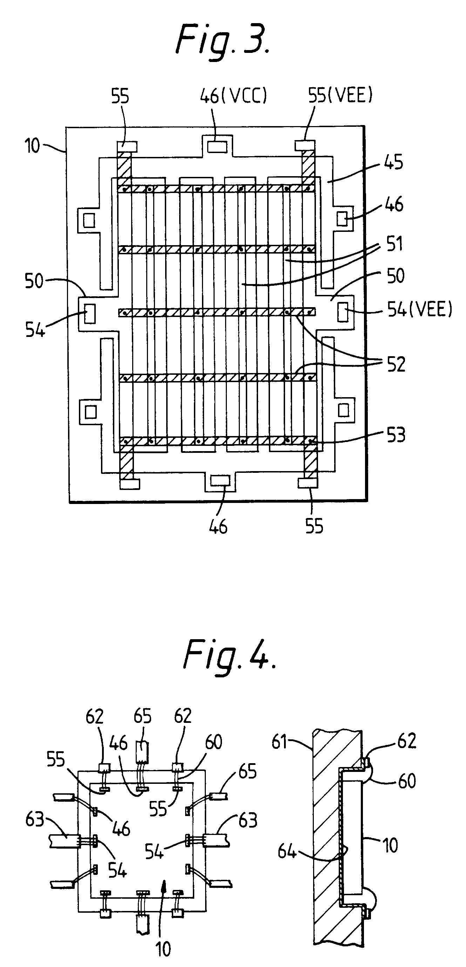

Figure 3 is a layout of the chip according to one embodiment of the present invention. The symbols used in Fig. 1 are used for the same portions in Fig. 3. The feature of the present invention in the embodiment shown in Fig. 3 is that pads 55 for the V_{EE} supply are added in four corners and the end members of the wiring pattern 52 of the second layer are extended thereto. By using such a construction, six bonding pads are formed on the V_{EE} side similar to those on the V_{CC} side. Therefore, the internal source voltage can be equalized. However, it would be undesirable for the number of external terminals of the package to be increased by such a construction.

Therefore, in the present invention, as is shown in Fig. 4, the pads 62 on the package 61 to which the pads 55 are connected via a bonding wire 60 are different from the pads 63 corresponding to the pads 54 in that the pads 62 are not connected to the external terminal. Instead pads 62, as well as pads 63, are connected to an electro-conductive layer 64 positioned in the bottom of the package 61. The layer 64 will usually be of aluminium. Alternatively, if the package 61 is formed from a multilayer ceramic, each layer has a wiring pattern, and these wiring patterns are connected via throughholes. In such a case, pads 62, 63 are also connected to the electro-conductive layer 64 via throughholes. In such a construction, the electro-conductive layer 64 is usually formed from gold, which has a lower resistivity than aluminium; or, if the layer 64 is not formed from gold the electro-conductive layer is wide and has a low resistance.

It will be seen that the provision of the layer 64, to which pads 62 and 63 are connected, is equivalent to extending the pads 62 to the exterior of the package.

Reference 65 indicates pads for connecting each pad 46 for the V_{CC} supply to an external lead.

## Claims

1. A semiconductor integrated circuit device comprising:
a semiconductor substrate in which integrated circuits are formed and on which a first power supply line layer (45,V_{CC}) and a second power supply line layer (50,51,52,V_{EE}) are formed;
a plurality of first internal pads (46) formed on the substrate and connected to the first power supply line layer;
second internal pads (54) formed on the substrate and connected to the second power supply line layer, the number of second internal pads (54) being less than the number of first internal pads (46);
a package (61) on which the substrate is mounted;
a plurality of first external pads (65) formed on the package and around the peripheral area of the substrate, the first external pads being connected to the first internal pads (46) through respective conductors;
for each second internal pad (54), a second external pad (63) formed on the package and at the peripheral area of the substrate, each second external pad being connected to a second internal pad (54) through a conductor and, each of said first and second external pads also being connected to an external terminal lead;
and characterised by at least one third internal pad (55) formed on the substrate and connected to the second power supply line layer;
for each third internal pad (55), a third external pad (62) formed on the package and around the peripheral area of the substrate, the third external pad being connected to the third interral pad through a conductor but having no connection to an external lead; and
an electroconductive layer (64) formed over a substantial portion of the interface between the substrate and the surface of the package, the electroconductive layer (64) extending to and being connected to the second and the third external pads (63,62), thereby removing the need for an additional external terminal lead for the third external pad (62).

2. An integrated circuit device according to the claim 1, wherein the substrate is of rectangular shape, and two second internal pads (54) are provided at intermediate points on opposite sides of the substrate; and in which
third internal pads (55) are formed adjacent the four corners of the substrate.

## Patentansprüche

1. Integrierte Halbleiterschaltungsvorrichtung, die folgendes umfasst:
ein Halbleitersubstrat, in dem integrierte Schaltungen gebildet sind, und auf dem eine erste Netzleitungsschicht (45,V_{CC}) und eine zweite Netzleitungsschicht (50,51,52,V_{EE}) gebildet sind;
eine Vielzahl von ersten inneren Feldern (46), die auf dem Substrat gebildet sind und an die erste Netzleitungsschicht angeschlossen sind;
zweite innere Felder (54), die auf dem Substrat gebildet sind und an die zweite Netzleitungsschicht angeschlossen sind, wobei die Anzahl der zweiten inneren Felder (54) geringer als die Anzahl der ersten inneren Felder (46) ist;
eine Baueinheit (61), auf der das Substrat angebracht ist;
eine Vielzahl von ersten äusseren Feldern (65), die auf der Baueinheit und um das periphere Gebiet des Substrats gebildet sind, wobei die ersten äusseren Felder durch entsprechende Leiter an die ersten inneren Felder (46) angeschlossen sind;
ein zweites, auf der Baueinheit und an dem peripheren Gebiet des Substrats gebildetes äusseres Feld (63) für jedes zweite innere Feld (54), wobei jedes zweite äussere Feld durch einen Leiter an ein zweites inneres Feld (54) angeschlossen ist und jedes der ersten und zweiten äusseren Felder auch an eine äussere Endleitung angeschlossen ist;
und die durch wenigstens ein drittes inneres Feld (55) gekennzeichnet ist, das auf dem Substrat gebildet und an die zweite Netzleitungsschicht angeschlossen ist;
ein drittes, auf der Baueinheit und um das periphere Gebiet gebildetes äusseres Feld (62) für jedes dritte innere Feld (55), wobei das dritte äussere Feld durch einen Leiter an das dritte innere Feld angeschlossen ist, aber keinen Anschluss an eine äussere Leitung hat; und
eine über einem wesentlichen Teil der Grenzfläche zwischen dem Substrat und der Oberfläche der Baueinheit gebildete elektrisch leitende Schicht (64), wobei die elektrisch leitende Schicht (64) sich auf die zweiten und dritten äusseren Felder (63,62) erstreckt und daran angeschlossen ist, dabei wird der Bedarf nach einer zusätzlichen Endleitung für das dritte äussere Feld (62) beseitigt.

2. Integrierte Halbleiterschaltungsvorrichtung nach Anspruch 1, in der das Substrat eine rechteckige Gestalt hat, und zwei innere Felder (54) an dazwischen liegenden Punkten auf gegenüberliegenden Seiten des Substrats vorgesehen sind; und in der dritte innere Felder (55) neben den vier Ecken des Substrats gebildet sind.

## Revendications

1. Dispositif de circuit intégré à semi-conducteurs comprenant :
un substrat semi-conducteur dans lequel sont formés des circuits intégrés et sur lequel sont formées une première couche de lignes d'alimentation en énergie (45, V_{CC}) et une seconde couche de lignes d'alimentation en énergie (50, 51, 52, V_{EE}) ;
une pluralité de premiers plots internes (46) formés sur le substrat et reliés à la première couche de lignes d'alimentation en énergie ;
des deuxièmes plots internes (54) formés sur le substrat et reliés à la seconde couche de lignes d'alimentation en énergie, le nombre des deuxièmes plots internes (54) étant plus petit que le nombre des premiers plots internes (46) ;
un boîtier (61) dans lequel le substrat est monté ;
une pluralité de premiers plots externes (65) formés sur le boîtier et autour de la zone périphérique du substrat, les premiers plots externes étant reliés aux premiers plots internes (46) par des conducteurs respectifs ;
pour chaque deuxième plot interne (54), un deuxième plot externe (63) formé sur le boîtier et au droit de la zone périphérique du substrat, chaque deuxième plot externe étant relié à un deuxième plot interne (54) par un conducteur et, chacun desdits premiers et deuxièmes plots externes étant également reliés à un conducteur de borne externe ;
et caractérisé par au moins un troisième plot interne (55) formé sur le substrat et relié à la seconde couche de lignes d'alimentation en énergie ;
pour chaque troisième plot interne (55), un troisième plot externe (62) formé sur le boîtier et autour de la zone périphérique du substrat, le troisième plot externe étant relié au troisième plot interne par un conducteur mais n'ayant de liaison avec aucun conducteur externe ; et
une couche conductrice de l'électricité (64) formée sur une partie substantielle de l'interface entre le substrat et la surface du boîtier, la couche conductrice de l'électricité (64) s'étendant jusqu'aux deuxièmes et troisièmes plots externes (63, 62) et étant reliée à ceux-ci, en éliminant par ce moyen le besoin d'un conducteur de borne externe supplémentaire pour le troisième plot externe (62).

2. Dispositif de circuit intégré selon la revendication 1, dans lequel le substrat est de forme rectangulaire, et deux deuxièmes plots internes (54) sont disposés en des points intermédiaires de chaque côté du substrat ; et dans lequel des troisièmes plots internes (55) sont formés adjacents aux quatres coins du substrat.
